# EUROPÄISCHE PATENTSCHRIFT

(11) **EP 1 069 518 B1**
(45) Veröffentlichungstag und Bekanntmachung des Hinweises auf die Patenterteilung: **15.01.2003**
(21) Anmeldenummer: 99810755.1
(22) Anmeldetag: 23.08.1999
(51) Int. Cl.: G06F 17/50

(54) **Berechnung und visuelle Darstellung von Spannungszuständen auf einem elektrischen Schaltschema**
Calculation and visual representation of voltage states in an electrical switching graph
Calculation et représentation visuelle d'états de tension dans un schéma de commutation électrique

(30) Priorität: 16.07.1999 EP 99810643
(43) Veröffentlichungstag der Anmeldung: 17.01.2001
(73) Patentinhaber: ABB Schweiz AG, 5400 Baden (CH)
(72) Erfinder: Wimmer, Wolfgang, 5323 Rietheim (CH); Mataji, Babak, 5430 Wettingen (CH)
(74) Vertreter: ABB Patent Attorneys

(56) Entgegenhaltungen:
- IMHOF K ET AL: "On the use of colours for presenting power system connectivity information" IEEE TRANSACTIONS ON POWER SYSTEMS, MAY 1990, USA, Bd. 5, Nr. 2, Seiten 574-581, XP002128159 ISSN: 0885-8950
- PIRES DE AZEVEDO G ET AL: "Enhancing the human-computer interface of power system applications" IEEE TRANSACTIONS ON POWER SYSTEMS, MAY 1996, IEEE, USA, Bd. 11, Nr. 2, Seiten 646-653, XP002128160 ISSN: 0885-8950
- FOLEY M ET AL: "Object-oriented on-line network analysis" IEEE TRANSACTIONS ON POWER SYSTEMS, FEB. 1995, USA, Bd. 10, Nr. 1, Seiten 125-132, XP002128161 ISSN: 0885-8950

## Beschreibung

### Technisches Gebiet

Die Erfindung bezieht sich auf das Gebiet der Leittechnik. Sie bezieht sich auf ein computer-implementiertes Verfahren, ein Computersystem und ein Computerprogrammprodukt zur Berechnung und visuellen Darstellung von Spannungszuständen auf einem elektrischen Schaltschema einer Schaltanlage gemäss dem Oberbegriff der unabhängigen Patentansprüche.

### Stand der Technik

Schaltanlagen für die Energieverteilung in Hoch- und Mittelspannungsnetzen sind mit Bedienstationen zur Steuerung der Anlagen ausgerüstet. Dazu weisen solche Bedienstationen eine Visualisierung einer Topologie der Anlage auf, welche Komponenten wie elektrische Leitungen, Sammelschienen, Schalter und Transformatoren als elektrisches Schaltschema auf einem Bildschirm darstellt. Dabei werden die Phasen eines elektrischen Dreiphasensystems in einem Einzelliniendiagramm zu einer einzigen Linie zusammengefasst.

Es ist bekannt, in Schemata zur Darstellung elektrischer Verteilnetze die Linien, welche bestimmte elektrische Leitungen darstellen, mit einer Farbe darzustellen, welche einen Spannungszustand dieser Leitung repräsentiert. Eine entsprechende Einfärbung von Leitungen in einem Schaltschema einer Hoch- oder Mittelspannungsschaltanlage ist nicht üblich, weil dies eine aufwendige Modellierung einer Struktur und eines Verhaltens der Schaltanlage bedingt, da die Komplexität einer Schaltanlage wesentlich grösser ist als jene eines Verteilnetzes. Entsprechende Modelle sind anlagenspezifisch und lassen sich nicht wiederverwerten.

Die Dissertation "Interaktives Visualisierungssystem mit automatischem Design für die Betriebsführung elektrischer Netze", Kapitel 3 und 4, von Wolfgang Kempinski, Universität Duisburg, 7.01.1999, zeigt eine Einfärbung von Linien einer visuellen Darstellung einer Schaltanlage nach Massgabe von Spannungsebenen. Spannungswerte werden mittels einer Lastflussrechnung anhand eines Modells der Anlage ermittelt, das heisst, durch Lösung eines nichtlinearen Gleichungssystems, welches für jede Komponente eines Netzes ein Verhältnis zwischen Spannung und Strom respektive aufgenommener Leistung beschreibt. Dieses Vorgehen erfordert eine detaillierte Modellierung des elektrischen Verhaltens jeder Komponente und ein aufwendiges numerisches Verfahren zur Lösung eines nichtlinearen Gleichungssystems, welches nicht immer zu einer Lösung führt.

Der Artikel "Trainingssimulator für die Betriebsführung elektrischer Netze", Elektrie 51(1997)H.5/6, S.193-201, von Wolfgang Kempinski, zeigt, wie eine aktuelle Topologie eines elektrischen Netzes durch systematisches Durchsuchen eines Datenmodells und Ermittlung eingeschalteter Netzteile ermittelt wird. Diese aktuelle Topologie liegt der oben erwähnten Lastflussrechnung zugrunde.

### Darstellung der Erfindung

Es ist deshalb Aufgabe der Erfindung, ein computer-implementiertes Verfahren, ein Computersystem und ein Computerprogrammprodukt zur Berechnung und visuellen Darstellung von Spannungszuständen auf einem elektrischen Schaltschema der eingangs genannten Art zu schaffen, welche eine einfache Modellierung einer Struktur und eines Verhaltens einer Schaltanlage ermöglichen, wobei sich die Modellierung effizient auf verschiedene Anlagen anwenden lässt und die Bestimmung von Spannungszuständen vereinfacht und beschleunigt wird.

Diese Aufgabe lösen ein computer-implementiertes Verfahren, ein Computersystem und ein Computerprogrammprodukt zur Berechnung und visuellen Darstellung von Spannungszuständen auf einem elektrischen Schaltschema einer Schaltanlage mit den Merkmalen der unabhängigen Patentansprüche.

Im erfindungsgemässen Verfahren zur Berechnung und visuellen Darstellung von Spannungszuständen auf einem elektrischen Schaltschema einer Schaltanlage werden Spannungszustände von Leitern anhand von angenommenen oder gemessenen realen Schalterstellungen und Spannungen einer Anlage bestimmt und Bildelemente des Schaltschemas entsprechend den Spannungszuständen eingefärbt, wobei das Verfahren ein Topologiemodell der Anlage verwendet, welches virtuelle Quellen, Schalter und Leitungen als Elementarbausteine, sowie Komponentenregeln zur Bestimmung von Schalterzuständen in Abhängigkeit von Leitungszuständen aufweist.

Anstelle von oder zusätzlich zu einer Einfärbung von Bildelementen kann die Darstellung von Spannungszuständen auch durch die Variation von anderen Linieneigenschaften wie Linienstärken, Mustern oder Helligkeiten vorgenommen werden.

In einer bevorzugten Variante der Erfindung wird das Topologiemodell aus einem Einzelliniendiagramm, welches Komponenten einer Schaltanlage wie beispielsweise Leitungen, Sammelschienen, Schalter, Generatoren und Transformatoren darstellt, sowie aus Komponentendaten, das heisst Komponentenstrukturdaten, Komponentenregeln und Komponentenparametern einzelner Komponenten erzeugt.

Die Komponentenstrukturdaten einer Komponente beschreiben vorteilhafterweise einen Aufbau einer generischen Komponente anhand von virtuellen Quellen, Schaltern und Leitungen als Elementarbausteinen. Die Komponentenregeln definieren vorteilhafterweise die Zustände von virtuellen Schaltern in Abhängigkeit von Spannungszuständen von virtuellen Leitungen der Komponente. Die Komponentenparameter beschreiben spezifische Parameter einer realen Komponente.

Die Trennung von Einzelliniendiagramm, Komponentendaten und Topologiemodell erlaubt es, Komponentenstrukturen und Komponentenregeln wiederzuverwenden und dadurch verschiedene Anlagen effizient zu modellieren.

Die Verwendung derselben einfachen Elementarbausteine in allen Komponentenstrukturen erlaubt, ein standardisiertes Analyseverfahren zur Analyse des gesamten Topologiemodells und zur Bestimmung von Linieneigenschaften zu verwenden.

Weitere bevorzugte Ausführungsformen gehen aus den abhängigen Patentansprüchen hervor.

### Kurze Beschreibung der Zeichnungen

Im folgenden wird die Erfindung anhand eines bevorzugten Ausführungsbeispiels, welches in den beiliegenden Zeichnungen dargestellt ist, näher erläutert. Es zeigen:
- Figur 1: ein Einzelliniendiagramm einer Schaltanlage;
- Figur 2: ein Datenflussdiagramm einer Erzeugung eines Topologiemodells; und
- Figur 3: eine Darstellung einer Komponente mittels Elementarbausteinen.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

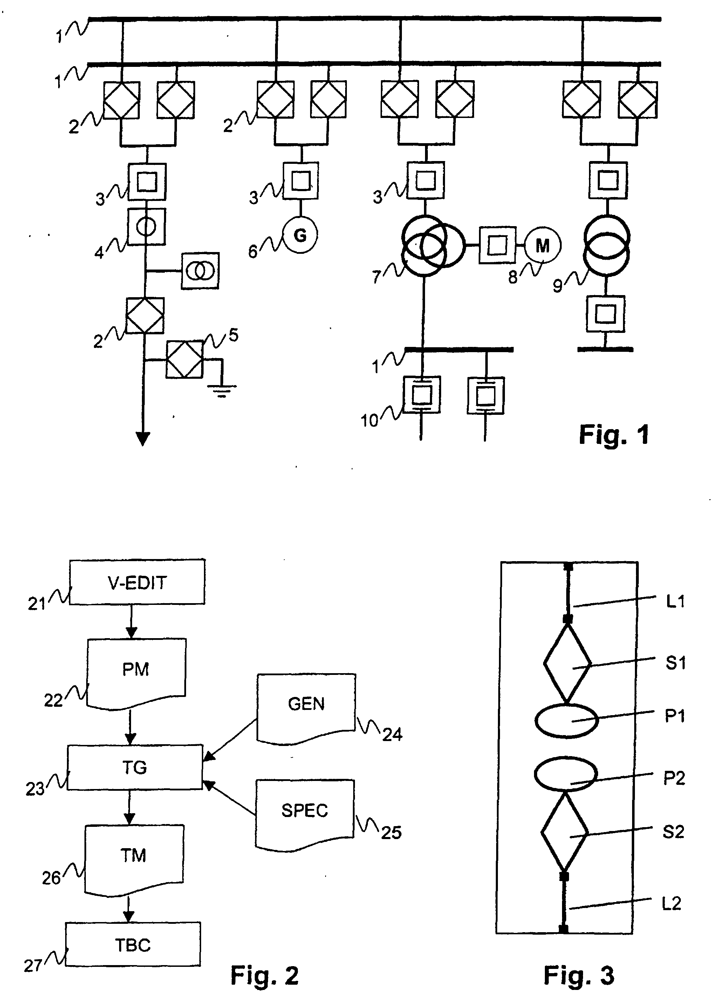

Die Figur 1 zeigt ein Einzelliniendiagramm einer Schaltanlage mit Sammelschienen 1, Abtrennschaltern 2, Schaltern 3, einem Stromwandler 4, Spannungswandler 5, Generator 6, Dreiwindungstransformator 7, Motor 8, Zweiwindungstransformator 9 und Leistungsschaltern mit Wagen (circuit breakers with truck) 10.

Figur 2 zeigt als Überblick über die folgenden Ausführungen ein Datenflussdiagramm: Mittels eines Eingabeprogramms 21 wird ein Anlagenmodell 22 erzeugt. Aus dem Anlagenmodell 22, einer Menge 24 von generischen Komponentenmodellen und spezifischen Komponentendaten 25 wird mittels eines Topologiegenerators 23 ein Topologiemodell 26 erzeugt. Das Topologiemodell 26 wird in einem Analyse verfahre n 27 zur Bestimmung von Spannungszuständen analysiert.

Ein Einzelliniendiagramm wird durch einen Benutzer mittels eines Eingabemittels, beispielsweise eines graphischen Eingabeprogramms 21 eines Datenverarbeitungsgerätes oder Rechners in bekannter Weise gezeichnet. Dabei werden einzelne Bildelemente, welche Komponenten der Schaltanlage repräsentierten, innerhalb eines durch ein graphisches Ausgabegerät angezeigten Bildes plaziert und miteinander verbunden. Aufgrund dieser Eingabe werden im Rechner Datenstrukturen, welche die Topologie der Anlage repräsentieren, erzeugt und vorzugsweise in einer Datei abgespeichert. Diese Daten werden Anlagenmodell 22 genannt. Ein Anlagenmodell 22 kann auch aus mehreren Bildern, welche verschiedene Teile der Anlage repräsentieren, gebildet werden. Spezielle Bildelemente repräsentieren Leitungen zu andern Schaltanlagen oder Netzen, mit denen bei einer späteren Bestimmung von Spannungszuständen ein Datenaustausch stattfindet.

Anhand des Anlagenmodells 22 erzeugt ein Mittel zur Verarbeitung des Anlagen modells oder ein Topologiegenerator 23 ein rechnerbasiertes respektive computerlesbares Topologiemodell 26, welches aus Elementarbausteinen aufgebaut ist. Elementarbausteine sind virtuelle Quellen, Schalter und Leitungen. Das Topologiemodell 26 dient zur Bestimmung von Spannungszuständen der Anlage. Zum besseren Verständnis werden vorerst das Topologiemodell 26 und die Bestimmung von Spannungszuständen erklärt, und anschliessend die Erzeugung des Topologiemodells 26.

Das Topologiemodell 26 ist ein Graph, dessen Zweige Elementarbausteine, also virtuelle Leitungen, Schalter oder Quellen sind. Leitungen und Schalter sind jeweils mit zwei Knoten des Graphs verbunden, Quellen jeweils nur mit einem Knoten. Knoten sind auch mit einer Erdung verbindbar. Schalter befinden sich entweder in einem ersten, geschlossenen oder eingeschalteten Zustand, oder in einem zweiten, geöffneten oder ausgeschalteten Zustand, oder in einem dritten, unbekannten. Zustand.

Leitungen weisen Spannungszustände auf. Es werden davon vier Hauptzustände unterschieden, je nachdem womit eine Leitung verbunden ist. Verbindungen einer Leitung zu einer Quelle oder Erdung sind gegeben, wenn die Quelle oder Erdung an einem gleichen Knoten wie die Leitung liegt, oder wenn die Quelle oder Erdung über andere Leitungen und über geschlossene Schalter mit der Leitung verbunden ist. Hauptzustände sind:
- Passiv: Die Leitung ist nicht geerdet und nicht mit einer Quelle verbunden.
- Geerdet: Die Leitung ist geerdet und nicht mit einer Quelle verbunden.
- Unbekannt: Beispielsweise ist die Leitung mit einer Quelle verbunden und gleichzeitig geerdet, oder die Leitung ist mit einem Schalter verbunden, welcher sich im unbekannten Zustand befindet.
- Aktiv: Die Leitung ist mit einer Quelle verbunden. Die Quelle entspricht beispielsweise einem Generator, einer Seite einer Transformators, oder einer Speiseleitung, welche von aussen zur modellierten Schaltanlage führt.
Der Hauptzustand "Aktiv" weist Unterzustände oder Prioritäten auf, welche beispielsweise unterschiedlich hohen Spannungswerten entsprechen. Vorteilhafterweise wird dabei eine begrenzte Anzahl von diskreten Unterzuständen verwendet. Jedem Haupt- oder Unterzustand ist eine Eigenschaft oder Kombination von Eigenschaften zugeordnet, welche beim Darstellen des Einzelliniendiagramms verwendet wird. Solche Eigenschaften sind vorzugsweise die Farbe einer Linie oder eines Bildelementes, aber auch Liniendicken, Muster oder Helligkeiten. Der Einfachheit halber sind in der folgenden Beschreibung vor allem Farben erwähnt, wobei die anderen Linieneigenschaften mit gemeint sind. Vorteilhafterweise werden Unterzuständen, die nahe beieinanderliegenen Prioritäten oder Spannungswerten entsprechen, ähnliche Farben oder die gleiche Farbe zugeordnet.

In einer Variante der Erfindung repräsentieren eine oder mehrere virtuelle Quellen reale Spannungsquellen wie beispielsweise Einspeisungen oder Generatoren. Dabei markieren unterschiedliche Unterzustände resp. Prioritäten der virtuellen Quellen neben der Spannung auch die Identität unterschiedlicher realen Spannungsquellen. Dadurch wird durch die Einfärbung des Einzelliniendiagramms sichtbar, welche Verbraucher von einer bestimmten Einspeisung gespiesen werden.

In einer weiteren Variante der Erfindung repräsentieren eine oder mehrere virtuelle Quellen nicht reale Spannungsquellen sondern reale Spannungswandler. Dabei wird vorteilhafterweise jeder virtuellen Quelle eine unterschiedliche Priorität zugeordnet, was unterschiedlichen Unterzuständen oder Spannungen entspricht. Das eingefärbte Einzelliniendiagramm zeigt nun bei jedem offenen Schalter, anhand der Farben der an den Schalter angrenzenden Leitungen, welche Spannungswandler die Spannung dieser angrenzenden Leitungen messen. Diese Spannungswandler werden zur Überprüfung der Synchronisation der Spannungen vor einem Schliessen des Schalters herangezogen. Weiter sollten gleich eingefärbte Spannungswandler die gleiche Spannung messen, was eine Plausibilitätsüberprüfung der Spannungswandler erlaubt.

Zur Analyse 27 einer Schaltanlage anhand des entsprechenden Topologiemodells 26 wird in einem entsprechenden Mittel 27 zur Auswertung des Topologiemodells davon ausgegangen, dass Spannungszustände von einzelnen Quellen sowie die Stellungen von Schaltern, welche realen Schaltern entsprechen, bekannt sind. Dazu weist der Rechner eine Kommunikationsverbindung zu einer realen Schaltanlage auf, mittels welcher gemessene Spannungen und Schalterzustände übermittelt werden. In einer anderen Ausführungsform der Erfindung ist der Rechner nicht mit einer realen Schaltanlage verbunden, sondern es werden Werte für bestimmte Spannungen und Schalterstellungen als vorgegeben angenommen. Ausgehend von diesen gemessenen oder angenommenen Spannungen werden im Topologiemodell 26 entsprechende Quellen als aktiv mit einem entsprechenden Unterzustand gesetzt, und ausgehend von den gemessenen oder angenommenen Schalterstellungen werden Zustände von virtuellen Schaltern des Topologiemodells 26 als geöffnet oder geschlossen gesetzt. Ausgehend von aktiven Quellen werden die Spannungszustände von Leitungen gemäss Propagationsregeln ermittelt. Propagationsregeln sind beispielsweise:
- Wenn eine erste Leitung, deren Spannungszustand noch nicht bestimmt worden ist, eine Quelle oder eine zweite Leitung mit bekanntem Spannungszustand trifft, das heisst, dass die erste Leitung über einen gemeinsamen Knoten oder einen geschlossenen Schalter mit der Quelle respektive der zweiten Leitung verbunden ist, so erhält die erste Leitung den Zustand der Quelle respektive der zweiten Leitung.
- Wenn eine geerdete Leitung auf eine aktive Leitung trifft, wird der Zustand für beide Leitungen als unbekannt gesetzt.
- Wenn zwei aktive Leitungen aufeinandertreffen, erhalten beide als Unterzustand die höhere Priorität der beiden Leitungen.
- Wenn eine Leitung auf einem Schalter mit unbekanntem Zustand trifft, wird der Zustand der Leitung als unbekannt gesetzt.
Weitere Kombinationen von Zuständen werden durch entsprechende weitere Propagationsregeln behandelt. Die Gesamtheit dieser Regeln sowie ein Verfahren zur Abarbeitung der Regeln bilden das Analyseverfahren 27 zur Bestimmung von Spannungszuständen.

Um das Topologiemodell 26 erzeugen zu können, benötigt der Topologiegenerator 23 Informationen über einen inneren Aufbau und eine Funktionsweise der Komponenten. Diese Informationen sind einerseits generischer, andererseits spezifischer Art.

Generische Informationen beschreiben einen Typ oder eine Klasse von Geräten, beispielsweise Schalter oder Transformatoren. Generische Informationen über eine Komponente werden auch als Komponentenmodell bezeichnet. Sie beinhalten eine Komponentenstruktur, das heisst, eine Repräsentation der Komponente durch Elementarbausteine, sowie Komponentenregeln, das heisst Regeln über das Verhalten einzelner Elementarbausteine der Komponente in Abhängigkeit von Spannungszuständen anderer Elementarbausteine der Komponente. Komponentenmodelle werden nur einmal erzeugt, beispielsweise bei der Erstellung oder Verbesserung von Softwarewerkzeugen zur Realisierung der Erfindung. Aus mehreren Komponentenmodellen wird ein Satz 24 von Komponentenmodellen gebildet und in der Darstellung und Analyse beliebiger Schaltanlagen wiederverwendet.

Figur 3 zeigt die Komponentenstruktur eines Transformators mit zwei Wicklungssätzen. Auf einer ersten Seite des Transformators ist eine erste virtuelle Leitung L1 über einen ersten virtuellen Schalter S1 mit einer ersten virtuellen Quelle P1 verbunden, und auf einer zweiten Seite des Transformators ist eine zweite virtuelle Leitung L2 über einen zweiten virtuellen Schalter S2 mit einer zweiten virtuellen Quelle P2 verbunden. Dazugehörige Komponentenregeln des Transformators besagen, dass der Schalter S2 geschlossen ist, falls die Leitung L1 aktiv ist, und dass der Schalter S1 geschlossen ist, falls die Leitung L2 aktiv ist.

Die Schalter S1 und S2 entsprechen keinen realen Schaltern, sondern bilden zusammen mit den Komponentenregeln des Transformators eine Repräsentation des Verhaltens des Transformators welches durch das oben beschriebene Analyseverfahren 27 verarbeitet werden kann.

Spezifische Informationen beschreiben einzelne, konkrete Geräte eines Typs, beispielsweise einen Transformator mit bestimmten Wicklungsverhältnissen und Nennspannungen. Im Zusammenhang mit dem Topologiemodell beschreiben spezifische Informationen Komponentenparameter wie Name und Nummer einer Komponente, sowie, welche Unterzustände ein Anschluss der Komponente in Abhängigkeit eines internen Zustands aufweisen kann. Beispielsweise wird ein Transformator durch die folgenden Parameter charakterisiert:
1. Stationsname
2. Unterstationsname
3. Gerätename
4. Geräteidentifikation
5. Unterzustand von Quelle 1
6. Unterzustand von Quelle 2
Die Unterzustände der Quellen werden auf den zugeordneten Leitungen wirksam, wenn die entsprechenden Schalter geschlossen sind. Die Gesamtheit aller Komponentendaten der Komponenten einer Anlage ist mit dem Bezugszeichen 25 bezeichnet.

Der Topologiegenerator 23 verknüpft die Komponentenstrukturen der einzelnen Komponenten eines gegebenen Einzelliniendiagramms zu einem Topologiemodell. Die Komponentenregeln und -daten 25 werden entsprechenden Elementarbausteinen des Topologiemodells 26 zugeordnet, so dass sie durch das Analyseverfahren 27 verarbeitbar sind. Das Analyseverfahren 27 bestimmt wie oben beschrieben zugeordnete Spannungszustände von Quellen, Schaltern und Leitungen, indem
1. von angenommenen oder gemessenen realen Schalterstellungen und Spannungen ausgegangen wird,
2. daraus für mindestens eine erste Quelle oder eine erste Leitung ein Spannungzustand bestimmt wird,
3. und unter Verwendung von Propagationsregeln und Komponentenregeln Spannungszustände von übrigen, zweiten Leitungen und von übrigen, zweiten Quellen bestimmt werden.

Anschliessend setzt das Verfahren in einem Einzelliniendiagramm die Farben resp. Linieneigenschaften von Bildelementen nach Massgabe der Spannungszustände der Elementarbausteine der Komponenten, welche durch diese Bildelemente repräsentiert werden. Vorzugsweise werden dabei die Farben von Sammelschienen und anderen Leitungen des Einzelliniendiagramms gesetzt, aber auch Farben von Transformatoren, Generatoren und anderen Bildelementen, welche Anlagenkomponenten repräsentieren. Vorzugsweise ist das hier verwendete Einzelliniendiagramm dasselbe, welches mittels des Eingabeprogramms 21 erzeugt wurde.

In einer bevorzugten Variante der Erfindung erlauben Mittel zur Bestimmung einer visuellen Darstellung des Schaltschemas, Bildinhalte dieses Schaltschemas zu berechnen, und erlauben Mittel zur visuellen Darstellung des Schaltschemas, dieses Schaltschema an einem Bildschirm anzuzeigen und/oder mittels eines Druckers auszudrucken.

Die Programmelemente zur Umsetzung des erfindungsgemässen Analyseverfahrens und der visuellen Darstellung der Analyseresultate bilden zusammen ein erfindungsgemässes Computerprogrammprodukt. Dieses Computerprogrammprodukt bildet zusammen mit dem Topologiegenerator ein erfindungsgemässes Computerprogrammsystem, welches auf einem erfindungsgemässen Computersystem ausführbar ist. Dabei sind das Computerprogrammprodukt und das Computerprogrammsystem in bekannter Weise auf computerlesbaren Medien wie Disketten, CD-ROMs, Magnetbändern etc. speicherbar.

### Bezugszeichenliste

- 1: Sammelschiene
- 2: Abtrennschalter
- 3: Schalter
- 4: Stromwandler
- 5: Spannungswandler
- 6: Generator
- 7: Dreiwindungstransformator
- 8: Motor
- 9: Zweiwindungstransformator
- 10: Leistungsschalter mit Wagen (circuit breakers with truck)
- 21: Eingabeprogramm V-EDIT
- 22: Anlagenmodell PM
- 23: Topologiegenerator TG
- 24: Menge von generischen Komponentenmodellen GEN
- 25: spezifische Komponentendaten SPEC
- 26: Topologiemodell TM
- 27: Analyseverfahren TBC
- L1: erste virtuelle Leitung
- L2: zweite virtuelle Leitung
- S1: erster virtueller Schalter
- S2: zweiter virtueller Schalter
- P1: erste virtuelle Quelle
- P2: zweite virtuelle Quelle

## Patentansprüche

1. Computer-implementiertes Verfahren zur Berechnung und visuellen Darstellung von Spannungszuständen auf einem elektrischen Schaltschema, welches Komponenten einer Schaltanlage darstellt, wobei Linien, welche elektrische Leiter darstellen, nach Massgabe von Schalterstellungen und Spannungen der Schaltanlage mit unterschiedlichen Linieneigenschaften dargestellt werden, **dadurch gekennzeichnet,**
**dass** dabei ein Topologiemodell (26), welches als Elementarbausteine virtuelle Quellen, virtuelle Schalter und virtuelle Leitungen beinhaltet, verwendet wird, wobei eine Komponente jeweils
• durch einen Elementarbaustein oder durch eine bestimmte generische Kombination von Elementarbausteinen,
• durch spezifische Komponentenparameter, welche einzelne Komponenten beschreiben, sowie
• durch generische Komponentenregeln, welche jeweils für eine Klasse von Komponenten ein Verhalten einzelner Elementarbausteine der Komponente in Abhängigkeit von Spannungszuständen anderer Elementarbausteine der Komponente beschreiben,
repräsentiert wird,
**dass** jeder virtuellen Quelle und virtuellen Leitung jeweils ein eigener Spannungszustand zugeordnet wird, indem von angenommenen oder gemessenen realen Schalterstellungen und Spannungen ausgegangen wird, daraus für mindestens eine erste virtuelle Quelle oder eine erste virtuelle Leitung ein Spannungzustand bestimmt wird, und unter Verwendung von Propagationsregeln und Komponentenregeln Spannungszustände von übrigen, zweiten virtuellen Leitungen und von übrigen, zweiten virtuellen Quellen bestimmt werden,
wobei die folgenden Spannungszustände verwendet werden:
• Geerdet: eine Leitung ist geerdet und nicht mit einer Quelle verbunden;
• Unbekannt: eine Leitung ist beispielsweise mit einer Quelle verbunden und gleichzeitig geerdet;
• Aktiv: eine Leitung ist mit einer Quelle verbunden; wobei der Spannungszustand "Aktiv" Unterzustände aufweist, welche unterschiedlich hohen Spannungswerten entsprechen;
und wobei die folgenden Propagationsregeln verwendet werden:
• wenn eine erste Leitung, deren Spannungszustand noch nicht bestimmt worden ist, eine Quelle oder eine zweite Leitung mit bekanntem Spannungszustand trifft, so erhält die erste Leitung den Zustand der Quelle respektive der zweiten Leitung;
• wenn eine geerdete Leitung auf eine aktive Leitung trifft, wird der Zustand für beide Leitungen als unbekannt gesetzt;
• wenn zwei aktive Leitungen aufeinandertreffen, erhalten beide als Unterzustand den höheren Spannungswert der beiden Leitungen;
und **dass** die Linieneigenschaften der visuellen Darstellung aufgrund der Spannungszustände der virtuellen Leitungen und virtuellen Quellen bestimmt werden, indem einem Spannungszustand eine Linieneigenschaft zugeordnet ist.

2. Verfahren gemäss Anspruch 1, **dadurch gekennzeichnet, dass** das Topologiemodell (26) aus einem Komponenten darstellenden Einzelliniendiagramm der Schaltanlage sowie aus Komponentenstrukturdaten, Komponentenparametern und Komponentenregeln erzeugt wird.

3. Verfahren gemäss Anspruch 1, **dadurch gekennzeichnet, dass** eine oder mehrere virtuelle Quellen reale Spannungswandler repräsentieren, und dass angenommene Spannungen Prioritäten von Spannungswandlern entsprechen.

4. Computersystem zur Berechnung und visuellen Darstellung von Spannungszuständen auf einem elektrischen Schaltschema, welches Komponenten einer Schaltanlage darstellt, wobei Linien, welche elektrische Leiter darstellen, nach Massgabe von Schalterstellungen und Spannungen der Schaltanlage mit unterschiedlichen Linieneigenschaften dargestellt sind, **dadurch gekennzeichnet,**
**dass** das Computersystem ein Topologiemodell (26), welches als Elementarbausteine virtuelle Quellen, virtuelle Schalter und virtuelle Leitungen aufweist, wobei eine Komponente jeweils
• durch einen Elementarbaustein oder durch eine bestimmte generische Kombination von Elementarbausteinen,
• durch spezifische Komponentenparameter, welche einzelne Komponenten beschreiben, sowie
• durch generische Komponentenregeln, welche jeweils für eine Klasse von Komponenten ein Verhalten einzelner Elementarbausteine der Komponente in Abhängigkeit von Spannungszuständen anderer Elementarbausteine der Komponente beschreiben,
repräsentiert ist,
Mittel (27) zur Auswertung dieses Topologiemodells (26)
• durch Bestimmung eines Spannungszustands von mindestens einer ersten virtuellen Quelle oder einer ersten virtuellen Leitung nach Massgabe von angenommenen oder gemessenen realen Schalterstellungen und Spannungen der Schaltanlage und
• durch Verwendung von Propagationsregeln und Komponentenregeln zur Bestimmung von Spannungszuständen von übrigen, zweiten virtuellen Leitungen und von übrigen, zweiten virtuellen Quellen,
wobei die Spannungszustände zumindest die folgenden sind:
• Geerdet: eine Leitung ist geerdet und nicht mit einer Quelle verbunden;
• Unbekannt: eine Leitung ist beispielsweise mit einer Quelle verbunden und gleichzeitig geerdet;
• Aktiv: eine Leitung ist mit einer Quelle verbunden; wobei der Spannungszustand "Aktiv" Unterzustände aufweist, welche unterschiedlich hohen Spannungswerten entsprechen;
und wobei die Propagationsregeln zumindest die folgenden sind:
• wenn eine erste Leitung, deren Spannungszustand noch nicht bestimmt worden ist, eine Quelle oder eine zweite Leitung mit bekanntem Spannungszustand trifft, so erhält die erste Leitung den Zustand der Quelle respektive der zweiten Leitung;
• wenn eine geerdete Leitung auf eine aktive Leitung trifft, wird der Zustand für beide Leitungen als unbekannt gesetzt;
• wenn zwei aktive Leitungen aufeinandertreffen, erhalten beide als Unterzustand den höheren Spannungswert der beiden Leitungen;
sowie Mittel zur visuellen Darstellung von Leitern der Anlage, wobei Linien zur Darstellung von Leitern mit unterschiedlichen Linieneigenschaften, welche Spannungszuständen dieser Leiter entsprechen, dargestellt sind, aufweist.

5. Computersystem gemäss Anspruch 4, **dadurch gekennzeichnet, dass** es Mittel zur Eingabe eines Einzelliniendiagramms der Schaltanlage und zur Erzeugung einer computerlesbaren Darstellung dieses Diagramms, sowie Mittel (23) zur Verarbeitung dieser Darstellung, von Komponentenstrukturdaten, Komponentenparametern und Komponentenregeln und zur Erzeugung eines Topologiemodells (26) aufweist.

6. Computerprogrammprodukt zur Berechnung und visuellen Darstellung von Spannungszuständen auf einem elektrischen Schaltschema, welches Komponenten einer Schaltanlage darstellt, wobei Linien, welche elektrische Leiter darstellen, nach Massgabe von Schalterstellungen und Spannungen der Schaltanlage mit unterschiedlichen Linieneigenschaften dargestellt sind, **dadurch gekennzeichnet,**
**dass** das Computerprogrammprodukt ein Topologiemodell (26), welches als Elementarbausteine virtuelle Quellen, virtuelle Schalter und virtuelle Leitungen aufweist, wobei eine Komponente jeweils
• durch einen Elementarbaustein oder
• durch eine bestimmte generische Kombination von Elementarbausteinen, durch spezifische Komponentenparameter, welche einzelne Komponenten beschreiben, sowie
• durch generische Komponentenregeln, welche jeweils für eine Klasse von Komponenten ein Verhalten einzelner Elementarbausteine der Komponente in Abhängigkeit von Spannungszuständen anderer Elementarbausteine der Komponente beschreiben, repräsentiert ist,
Mittel (27) zur Auswertung dieses Topologiemodells (26)
• durch Bestimmung eines Spannungszustands von mindestens einer ersten virtuellen Quelle oder einer ersten virtuellen Leitung nach Massgabe von angenommenen oder gemessenen realen Schalterstellungen und Spannungen der Schaltanlage und
• durch Verwendung von Propagationsregeln und Komponentenregeln zur Bestimmung von Spannungszuständen von übrigen, zweiten virtuellen Leitungen und von übrigen, zweiten virtuellen Quellen,
wobei die Spannungszustände zumindest die folgenden sind:
• Geerdet: eine Leitung ist geerdet und nicht mit einer Quelle verbunden;
• Unbekannt: eine Leitung ist beispielsweise mit einer Quelle verbunden und gleichzeitig geerdet;
• Aktiv: eine Leitung ist mit einer Quelle verbunden; wobei der Spannungszustand "Aktiv" Unterzustände aufweist, welche unterschiedlich hohen Spannungswerten entsprechen;
und wobei die Propagationsregeln zumindest die folgenden sind:
• wenn eine erste Leitung, deren Spannungszustand noch nicht bestimmt worden ist, eine Quelle oder eine zweite Leitung mit bekanntem Spannungszustand trifft, so erhält die erste Leitung den Zustand der Quelle respektive der zweiten Leitung;
• wenn eine geerdete Leitung auf eine aktive Leitung trifft, wird der Zustand für beide Leitungen als unbekannt gesetzt;
• wenn zwei aktive Leitungen aufeinandertreffen, erhalten beide als Unterzustand den höheren Spannungswert der beiden Leitungen;
sowie Mittel zur Bestimmung einer visuellen Darstellung von Leitern der Anlage, wobei Linien zur Darstellung von Leitern mit unterschiedlichen Linieneigenschaften, welche Spannungszuständen dieser Leiter entsprechen, dargestellt sind, aufweist.

## Claims

1. Computer-implemented method for calculating and visually representing voltage states on an electrical circuit diagram showing components of a switching installation, lines which represent electrical conductors being shown using different line properties on the basis of switch positions and voltages in the switching installation, **characterized**
**in that** a topological model (26) containing virtual sources, virtual switches and virtual connections as elemental modules is used in this context, a component being respectively represented
• by an elemental module or by a particular generic combination of elemental modules,
• by specific component parameters which describe individual components, and
• by generic component rules which respectively describe for a class of components a response for individual elemental modules of the component on the basis of voltage states for other elemental modules of the component,
**in that** each virtual source and virtual connection has a particular dedicated voltage state associated with it by taking assumed or measured real switch positions and voltages as a basis, using these to determine a voltage state for at least one first virtual source or one first virtual connection, and determining voltage states of remaining, second virtual connections and of remaining, second virtual sources using propagation rules and component rules,
where the following voltage states are used:
• earthed: a connection is earthed and is not connected to a source;
• unknown: a connection is, by way of example, connected to a source and is simultaneously earthed;
• active: a connection is connected to a source; in this case, the voltage state "active" has substates which correspond to different levels of voltage values;
and where the following propagation rules are used:
• if a first connection, whose voltage state has not yet been determined, meets a source or a second connection having a known voltage state, then the first connection is given the state of the source or of the second connection;
• if an earthed connection meets an active connection, the state is set as unknown for both connections;
• if two active connections meet, both are given the higher voltage value on the two connections as a substate;
and **in that** the line properties in the visual representation are determined on the basis of the voltage states of the virtual connections and virtual sources by virtue of a voltage state having an associated line property.

2. Method according to claim 1, **characterized in that** the topological model (26) is produced from a single-line diagram, showing components, of the switching installation and from component structure data, component parameters and component rules.

3. Method according to claim 1, **characterized in that** one or more virtual sources represent real voltage transformers, and **in that** assumed voltages correspond to priorities of voltage transformers.

4. Computer system for calculating and visually representing voltage states on an electrical circuit diagram showing components of a switching installation, lines which represent electrical conductors being shown using different line properties on the basis of switch positions and voltages in the switching installation,
**characterized in that**
the computer system has a topological model (26) containing virtual sources, virtual switches and virtual connections as elemental modules, a component being respectively represented
• by an elemental module or by a particular generic combination of elemental modules,
• by specific component parameters which describe individual components, and
• by generic component rules which respectively describe for a class of components a response for individual elemental modules of the component on the basis of voltage states for other elemental modules of the component,
means (27) for evaluating this topological model (26)
• by determining a voltage state for at least one first virtual source or one first virtual line on the basis of assumed or measured real switch positions and voltages in the switching installation and
• by using propagation rules and component rules for determining voltage states for remaining, second virtual connections and for remaining, second virtual sources,
where the voltage states are at least the following:
• earthed: a connection is earthed and is not connected to a source;
• unknown: a connection is, by way of example, connected to a source and is simultaneously earthed;
• active: a connection is connected to a source; in this case, the voltage state "active" has substates which correspond to different levels of voltage values;
and where the propagation rules are at least the following:
• if a first connection, whose voltage state has not yet been determined, meets a source or a second connection having a known voltage state, then the first connection is given the state of the source or of the second connection;
• if an earthed connection meets an active connection, the state is set as unknown for both connections;
• if two active connections meet, both are given the higher voltage value on the two connections as a substate;
and means for visually representing conductors in the installation, lines for representing conductors being shown using different line properties corresponding to voltage states for these conductors.

5. Computer system according to claim 4, **characterized in that** it has means for inputting a single-line diagram of the switching installation and for producing a computer-readable representation of this diagram,
and means (23) for processing this representation, from component structure data, component parameters and component rules, and for producing a topological model (26).

6. Computer program product for calculating and visually representing voltage states on an electrical circuit diagram showing components of a switching installation, lines which represent electrical conductors being shown using different line properties on the basis of switch positions and voltages in the switching installation, **characterized in that**
the computer program product has a topological model (26) containing virtual sources, virtual switches and virtual connections as elemental modules, a component being respectively represented
• by an elemental module or
• by a particular generic combination of elemental modules, by specific component parameters which describe individual components, and
• by generic component rules which respectively describe for a class of components a response for individual elemental modules of the component on the basis of voltage states for other elemental modules of the component,
means (27) for evaluating this topological model (26)
• by determining a voltage state for at least one first virtual source or one first virtual line on the basis of assumed or measured real switch positions and voltages in the switching installation and
• by using propagation rules and component rules for determining voltage states for remaining, second virtual connections and for remaining, second virtual sources,
where the voltage states are at least the following:
• earthed: a connection is earthed and is not connected to a source;
• unknown: a connection is, by way of example, connected to a source and is simultaneously earthed;
• active: a connection is connectd to a source; in this case, the voltage state "active" has substates which correspond to different levels of voltage values;
and where the propagation rules are at least the following:
• if a first connection, whose voltage state has not yet been determined, meets a source or a second connection having a known voltage state, then the first connection is given the state of the source or of the second connection;
• if an earthed connection meets an active connection, the state is set as unknown for both connections;
• if two active connections meet, both are given the higher voltage value on the two connections as a substate;
and means for determining a visual representation of conductors in the installation, lines for representing conductors being shown using different line properties corresponding to voltage states of these conductors.

## Revendications

1. Procédé informatisé de calcul et de représentation visuelle d'états de tension sur un schéma de commutation électrique qui représente les éléments d'un équipement de commutation, les lignes qui représentent les conducteurs électriques étant représentées avec des caractéristiques de lignes différentes en fonction des positions des commutateurs et des tensions de l'équipement de commutation,
**caractérisé en ce**
**qu'**il emploie un modèle de topologie (26) qui comprend comme composants élémentaires des sources virtuelles, des commutateurs virtuels et des lignes virtuelles, un élément étant à chaque fois représenté
* par un composant élémentaire ou par une combinaison générique donnée de composants élémentaires,
* par des paramètres d'élément spécifiques qui décrivent chacun des éléments et
* par des règles d'élément génériques qui décrivent, à chaque fois pour une catégorie d'éléments, un comportement des composants élémentaires individuels de l'élément en fonction des états de tension des autres composants élémentaires de l'élément,
**qu'**un état de tension propre est à chaque fois attribué à chaque source virtuelle et ligne virtuelle en se basant sur des positions de commutateur et des tensions supposées ou mesurées réelles, duquel est déterminé un état de tension pour au moins une première source virtuelle ou une première ligne virtuelle et les états de tension des autres, deuxièmes lignes virtuelles et des autres, deuxièmes sources virtuelles sont déterminés en utilisant les règles de propagation et les règles des éléments,
les états de tension suivants étant utilisés :
* mis à la terre : une ligne est mise à la terre et non reliée à une source ;
* inconnu : une ligne est par exemple reliée à une source et en même temps mise à la terre ;
* actif : une ligne est reliée à une source, l'état de tension « actif » présentant des sous-états qui correspondent à différents niveaux de tension ;
et les règles de propagation suivantes étant utilisées :
* lorsqu'une première ligne dont l'état de tension n'a pas encore été déterminé rencontre une source ou une deuxième ligne dont l'état de tension est connu, la première ligne prend alors l'état de la source ou de la deuxième ligne ;
* lorsqu'une ligne mise à la terre rencontre une ligne active, l'état des deux lignes est considéré inconnu ;
* lorsque deux lignes actives se rencontrent, les deux prennent comme sous-état la valeur de la tension la plus élevée des deux lignes ;
et **que** les caractéristiques des lignes de la représentation visuelle sont déterminées en se basant sur les états de tension des lignes virtuelles et des sources virtuelles en associant une caractéristique de ligne à un état de tension.

2. Procédé selon la revendication 1, **caractérisé en ce que** le modèle de topologie (26) est créé à partir d'un graphique de lignes individuelles de l'équipement de commutation représentant des éléments ainsi qu'à partir des données structurelles des éléments, des paramètres des éléments et des règles des éléments.

3. Procédé selon la revendication 1, **caractérisé en ce qu'**une ou plusieurs sources virtuelles représentent des convertisseurs de tension réels et que les tensions supposées correspondent aux priorités des convertisseurs de tension.

4. Système informatisé de calcul et de représentation visuelle d'états de tension sur un schéma de commutation électrique qui représente les éléments d'un équipement de commutation, les lignes qui représentent les conducteurs électriques étant représentées avec des caractéristiques de lignes différentes en fonction des positions des commutateurs et des tensions de l'équipement de commutation, **caractérisé en ce**
**que** le système informatisé présente un modèle de topologie (26) qui comprend comme composants élémentaires des sources virtuelles, des commutateurs virtuels et des lignes virtuelles, un élément étant à chaque fois représenté
* par un composant élémentaire ou par une combinaison générique donnée de composants élémentaires,
* par des paramètres d'élément spécifiques qui décrivent chacun des éléments et
* par des règles d'élément génériques qui décrivent, à chaque fois pour une catégorie d'éléments, un comportement des composants élémentaires individuels de l'élément en fonction des états de tension des autres composants élémentaires de l'élément,
des moyens (27) pour analyser ce modèle de topologie (26)
* en déterminant un état de tension pour au moins une première source virtuelle ou une première ligne virtuelle en se basant sur des positions de commutateur et des tensions supposées ou mesurées réelles de l'équipement de commutation et
* en utilisant les règles de propagation et les règles des éléments pour déterminer les états de tension des autres, deuxièmes lignes virtuelles et des autres, deuxièmes sources virtuelles,
les états de tension étant au moins les suivants :
* mis à la terre : une ligne est mise à la terre et non reliée à une source ;
* inconnu : une ligne est par exemple reliée à une source et en même temps mise à la terre ;
* actif : une ligne est reliée à une source, l'état de tension « actif » présentant des sous-états qui correspondent à différents niveaux de tension ;
et les règles de propagation étant au moins les suivantes :
* lorsqu'une première ligne dont l'état de tension n'a pas encore été déterminé rencontre une source ou une deuxième ligne dont l'état de tension est connu, la première ligne prend alors l'état de la source ou de la deuxième ligne ;
* lorsqu'une ligne mise à la terre rencontre une ligne active, l'état des deux lignes est considéré inconnu ;
* lorsque deux lignes actives se rencontrent, les deux prennent comme sous-état la valeur de la tension la plus élevée des deux lignes ;
ainsi que des moyens de représentation visuelle des conducteurs de l'équipement, des lignes étant destinées à représenter les conducteurs ayant des caractéristiques de lignes différentes qui correspondent aux états de tension de ces conducteurs étant représentées.

5. Système informatisé selon la revendication 4, **caractérisé en ce qu'**il présente des moyens pour saisir un graphique de lignes individuelles de l'équipement de commutation et pour générer une représentation lisible par ordinateur de ce graphique ainsi que des moyens (23) pour traiter cette représentation des données structurelles des éléments, des paramètres des éléments et des règles des éléments et pour générer un modèle de topologie (26).

6. Programme informatique de calcul et de représentation visuelle d'états de tension sur un schéma de commutation électrique qui représente les éléments d'un équipement de commutation, les lignes qui représentent les conducteurs électriques étant représentées avec des caractéristiques de lignes différentes en fonction des positions des commutateurs et des tensions de l'équipement de commutation, **caractérisé en ce**
**que** le programme informatique présente un modèle de topologie (26) qui comprend comme composants élémentaires des sources virtuelles, des commutateurs virtuels et des lignes virtuelles, un élément étant à chaque fois représenté
* par un composant élémentaire ou
* par une combinaison générique donnée de composants élémentaires, par des paramètres d'élément spécifiques qui décrivent chacun des éléments et
* par des règles d'élément génériques qui décrivent, à chaque fois pour une catégorie d'éléments, un comportement des composants élémentaires individuels de l'élément en fonction des états de tension des autres composants élémentaires de l'élément,
des moyens (27) pour analyser ce modèle de topologie (26)
* en déterminant un état de tension pour au moins une première source virtuelle ou une première ligne virtuelle en se basant sur des positions de commutateur et des tensions supposées ou mesurées réelles de l'équipement de commutation et
* en utilisant les règles de propagation et les règles des éléments pour déterminer les états de tension des autres, deuxièmes lignes virtuelles et des autres, deuxièmes sources virtuelles,
les états de tension étant au moins les suivants :
* mis à la terre : une ligne est mise à la terre et non reliée à une source ;
* inconnu : une ligne est par exemple reliée à une source et en même temps mise à la terre ;
* actif : une ligne est reliée à une source, l'état de tension « actif » présentant des sous-états qui correspondent à différents niveaux de tension ;
et les règles de propagation étant au moins les suivantes :
* lorsqu'une première ligne dont l'état de tension n'a pas encore été déterminé rencontre une source ou une deuxième ligne dont l'état de tension est connu, la première ligne prend alors l'état de la source ou de la deuxième ligne ;
* lorsqu'une ligne mise à la terre rencontre une ligne active, l'état des deux lignes est considéré inconnu ;
* lorsque deux lignes actives se rencontrent, les deux prennent comme sous-état la valeur de la tension la plus élevée des deux lignes ;
ainsi que des moyens pour déterminer une représentation visuelle des conducteurs de l'équipement, des lignes étant destinées à représenter les conducteurs ayant des caractéristiques de lignes différentes qui correspondent aux états de tension de ces conducteurs étant représentées.
